# EUROPÄISCHE PATENTSCHRIFT

(11) **EP 0 434 933 B1**
(45) Veröffentlichungstag und Bekanntmachung des Hinweises auf die Patenterteilung: **24.05.1995**
(21) Anmeldenummer: 90120977.5
(22) Anmeldetag: 02.11.1990
(51) Int. Cl.: H05H 1/46, H01J 37/32

(54) **Einrichtung für die Erzeugung eines Plasmas durch Mikrowellen**
Device for microwave plasma generation
Dispositif à micro-ondes pour la génération de plasma

(30) Priorität: 23.12.1989 DE 3942963
(43) Veröffentlichungstag der Anmeldung: 03.07.1991
(73) Patentinhaber: LEYBOLD AKTIENGESELLSCHAFT, D-63450 Hanau (DE)
(72) Erfinder: Gesche, Roland, Dr., W-6453 Seligenstadt (DE); Kretschmer, Karl-Heinz, Dr., W-6070 Langen (DE)
(74) Vertreter: Schickedanz, Willi, Dipl.-Ing.

(56) Entgegenhaltungen:
- EP-A- 0 286 132
- EP-A- 0 311 696
- US-A- 3 287 730
- US-A- 4 877 509
- PATENT ABSTRACTS OF JAPAN, Band 13, Nr. 459, 17. Oktober 1989, Seite 126 E 832 & JP-A-1 179 323

## Beschreibung

Die Erfindung betrifft eine Einrichtung nach dem Oberbegriff des Patentanspruchs 1.

Eine derartige Einrichtung ist aus der US-A-4 877 509 bekannt.

Plasmen finden auf zahlreichen technischen Gebieten Anwendung. Beispielsweise dienen Plasmen zum Schweißen oder zum Beschichten von Folien. Es ist deshalb von großer Bedeutung, Plasmen gezielt und effektiv herzustellen. Unter einem Plasma versteht man ein elektrisches, im allgemeinen heißes Gemisch aus frei beweglichen positiven und negativen Ladungsträgern sowie elektrisch neutralen Atomen und Molekülen, die sich in ständiger ungeordneter Wärmebewegung befinden. Die Ladungsträger werden hierbei in der Regel durch Aufspaltung von neutralen Atomen und Molekülen gebildet. Die Energie hierfürwird durch Wärmezufuhr oder durch die Zufuhr von Strahlungs- oder Feldenergie aufgebracht.

Eine bekannte Einrichtung, mit Hilfe elektrostatischer Felder geladene Teilchen zu erzeugen, ist die Kaufmann-lonenquelle (US-A-3 156 090; L. D. Bollinger,"lon Milling for Semiconductor Processes", Solid State Technology, Nov. 1977, S. 66 bis 70), die eine Glühkathode und metallische Elektroden benötigt.

Bei einer anderen Einrichtung, die ohne Glühkathode arbeitet, sind ein 2,4 GHz-Magnetron, ein Hohlleiter und Kurzschlußschieber vorgesehen (US-A-4 058 748). Als Anregungsquelle dienen also Mikrowellen. Das elektrische Feld der elektromagnetischen Mikrowelle beschleunigt hierbei bereits vorhandene geladene Teilchen, so daß diese mit neutralen Teilchen häufiger zusammenstoßen und diese ionisieren.

Die Rate der erzeugten geladenen Teilchen wird dadurch erhöht, daß der elektromagnetischen Mi krowelle ein statisches Magnetfeld überlagert wird. Hierdurch entsteht eine sogenannte Elektronen-Zyklotron-Resonanz (ECR), wenn das statische magnetische Feld senkrecht auf dem elektrischen Wechselfeld der Mikrowelle steht. ECR-lonenquellen werden neuerdings in verstärktem Umfang eingesetzt.

Bei einer bekannnten ECR-Mikrowellen-Breitstrahl-lonenquelle zur Erzeugung eines großflächigen lonenstahls sind ein Hohlraumresonator, eine Magnetspule und ein Extraktionssystem vorgesehen (DD-PS 248 904). Die Mikrowellen werden hierbei über einen Eₒ₁-Rundhohlleiter eingeleitet.

In einer anderen Plasma-ECR-Erzeugungseinrichtung wird die Mikrowelle hybrid eingeführt, d.h. eine TE₁₀-Welle wird wenigstens teilweise in eine TM-Welle umgewandelt, um eine höhere Ausbeute bei der Plasmaerzeugung zu erreichen (EP-A1-0 311 696).

Weiterhin ist eine Einrichtung zum Erzeugen eines Plasmas durch zirkular polarisierte Mikrowellen bekannt, die einen Mikrowellenoszillator einen Modenwandler und eine Plasmakammer aufweist (vgl. die bereits erwähnte US-A-4 877 509).

Schließlich ist auch noch eine Antenne bekannt, mit der wellen mit veränderbarer Polarisation erzeugtwerden können (US-A-3 287 730). Zwischen den einzelnen Wellenleitern sind Drehmechanismen vorgesehen. Außerdem bezieht sich die bekannte Antenne nicht auf eine Plasmaerzeugungsanlage.

Der Erfindung liegt die Aufgabe zugrunde, eine Einrichtung für die Erzeugung von Plasma mittels zirkular polarisierten Mikrowellen zu schaffen, die im wesentlichen einfache Hohlleiter enthalten.

Diese Aufgabe wird gemäß den Merkmalen des Patentanspruchs 1 gelöst.

Der mit der Erfindung erzielte Vorteil besteht insbesondere darin, daß zur Erzeugung der zirkularen Polarisation ein handelsüblicher Wandler mit einem Standard-Rundhohlleiter als Ausgang verwendet werden kann. Aufgrund der Einspeisung einer zirkular polarisierten Grundwelle in ein Horn werden winkelabhängige höhere Moden nicht angeregt. Dies wird noch dadurch unterstützt, daß auch die Plasmakammer rotationssymmetrisch ausgebildet ist.

Ausführungsbeispiele der Erfindung sind in derZeichnung dargestellt und werden im folgenden näher beschrieben. Es zeigen:
Fig. 1a das elektrische und magnetische Feld einer harmonischen ebenen elektromagnetischen Welle, die sich nach rechts fortbewegt;
Fig. 1b eine zweite elektromagnetische Welle wie in Fig. 1a, jedoch zu dieser um 90° phasenverschoben;
Fig. 2 eine zirkular polarisierte elektrische Welle, die sich aus den elektrischen Wellen der Fig. 1a und 1 b zusammensetzt;
Fig. 3 eine Zeigerdarstellung mit der zirkular polarisierten elektromagnetischen Welle;
Fig. 4 eine bewegte elektrische Ladung in einem homogenen Magnetfeld;
Fig. 5 die Bahn eines positiven Teilchens in gekreuzten Feldern;
Fig. 6 eine Plasmaquelle, in die über einen Rundhohlleiter eine zirkular polarisierte Welle eingespeist wird;
Fig. 7 eine Mikrowelleneinstrahlung mit Rillenform;
Fig. 8 eine Mikrowelleneinstrahlung mit glockenförmiger Plasma-Begrenzungswand;
Fig. 9 eine graphische Darstellung der Abhängigkeit der mittleren kinetischen Energie von Elektronen von der magnetischen Feldstärke.

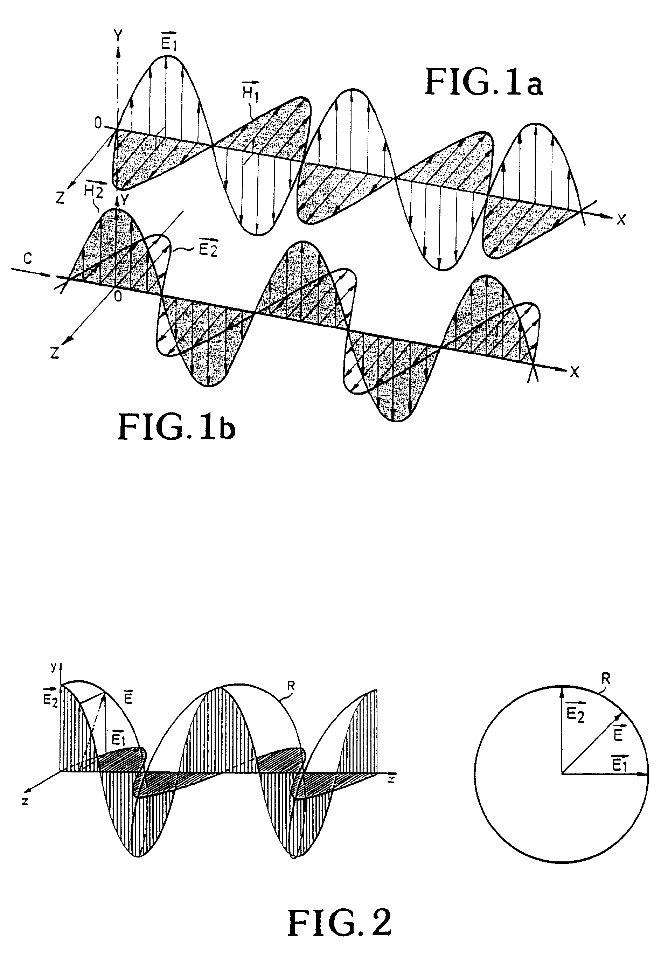

In der Fig. 1a ist eine ebene, linear polarisierte elektromagnetische Welle dargestellt, die sich entlang der x-Achse bewegt,d.h. nach rechts fortpflanzt. Diese Welle besteht aus einem elektrischen Wechselfeld E̅₁̅, das in y-Richtung zeigt, sowie aus einem magnetischen Wechselfeld H̅₁̅, das in z-Richtung zeigt. Die Welle heißt eben, weil E̅₁̅ und H̅₁̅ unabhängig von y und z sind, sich also in den Ebenen x = constant örtlich nicht ändern. Sie wird als linear polarisiert bezeichnet, weil sich die Spitzen der Feldvektoren an einem festen Ort zeitlich auf einer geraden Linie bewegen.

Die Fig. 1 zeigt eine ähnliche Welle mit den Feldern E2 und ^{H}₂ noch einmal, allerdings um 90° phasenverschoben und um 90° in der Y-Z-Ebene gedreht. Überlagert man die beiden Wellen gemäß Fig. 1a und Fig. 1 b und betrachtet man nun die elektrischen Felder, so ergibt sich die Darstellung der Fig. 2, wobei allerdings die Drehrichtung des Gesamtfelds eine andere ist. Man erkennt hierbei, daß sich die Feldvektoren E̅₂̅ und ^{E}_{I} zu einem Gesamtfeld E addieren. Wegen der 90°-Phasenverschiebung und der 90°-Drehung in der Y-Z-Ebene beschreibt die Resultierende R eine Spirale. Diese Spirale ist in der Fig. 2 rechtsdrehend, während die Addition der Fig. 1a und 1 b zu einer linksdrehenden Spirale führt. Aus der Sicht von der rechten Seite der x-Achse auf das Achsenkreuz der Fig.2 ergibt sich somit eine Vektordarstellung, wie sie auf rechten Seite der Fig.2 gezeigt ist.

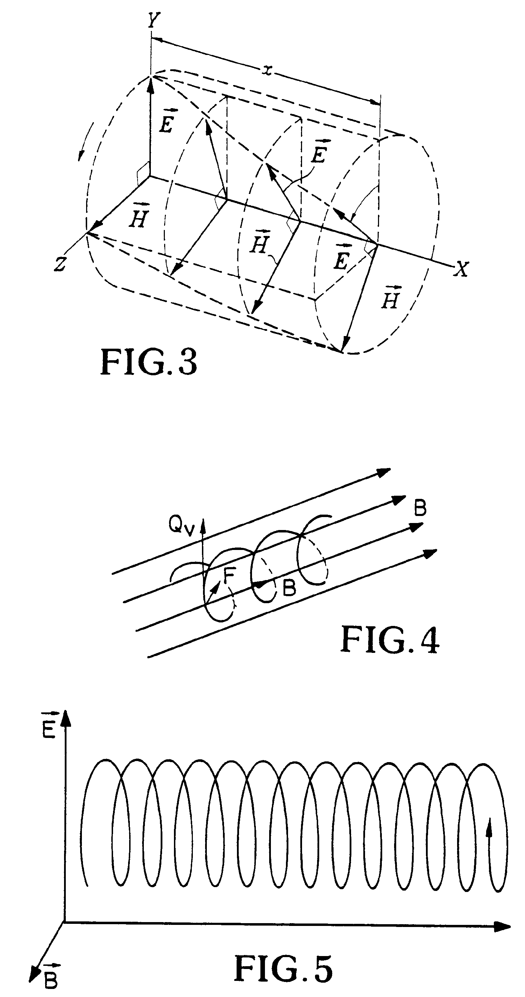

In der Fig. 3 sind die resultierenden H- und E-Wellen als Zeiger dargestellt, die um die x-Achse rotieren. Beide behalten ihren jeweiligen Betrag bei.

Vereinbarungsgemäß wird der elektrische Feldvektor _{E} als Repräsentant der gesamten Welle aufge- faßt, der auch die Polarisationseigenschaften bestimmt. Besitzen E̅₁̅ und E2 dieselbe Phase, so handelt es sich um eine linear polarisierte Welle. Tritt jedoch zwischen E̅₁̅ und E₂ eine Phasenverschiebung auf, so spricht man von einer elliptisch polarisierten Welle. Ein Spezialfall der elliptisch polarisierten Welle ist die zir- kular polarisierte Welle, bei der E_{I} und E2 denselben Betrag haben, aber eine Phasendifferenz von ϕ = π/2 aufweisen.

Bei Hohlleiterwellen, die oftfürdie Plasmaanregung verwendet werden, unterscheidet man zwischen TE-, TM und TEM-Wellen. Hat die magnetische Feldstärke einer Welle keine in Ausbreitungsrichtung fallende Komponente, so spricht man von einer TM-Welle. Bei der TM-Welle besitzt das elektrische Feld eine Komponente in Ausbreitungsrichtung, während das magnetische Feld rein transversal ist. Deshalb bezeichnet man die transversalmagnetischen oder TM-Wellen auch als E-Wellen. Besitzt dagegen die elektrische Feldstärke keine Komponente in Ausbreitungsrichtung, so handelt es sich um eine TE-Welle. Da in Ausbreitungsrichtung eine H-Komponente auftritt, wird die TE-Welle oder transversalelektrische Welle auch H-Welle genannt.

Eine elektromagnetische Welle, deren elektrisches oder magnetisches Feld rein transversal, d. h. senkrecht zur Ausbreitungsrichtung gerichtet sind, wird transversalelektromagnetische Welle oder TEM-Welle genannt. Bei den Wellen der Fig. 1a, 1 b und 2 handelt es sich somit um TEM-Wellen. Eine TEM-Welle ist in reinen Hohlleitern nicht ausbreitungsfähig, da die Randbedingungen E_{τangential} = 0,Hₙₒᵣₘₐₗ=0 an den metallischen Wänden dieses verbieten. Die E- und H-Felder werden in Eₘₙ- bzw. Hₘₙ-Moden klassifiziert, wobei m, n = 1,2,3,... die Anzahl der sin- bzw. cos-Halbperioden in der Feldverteilung senkrecht zur Ausbreitungsrichtung längs jeweils einer Strecke zwischen zwei Wänden angibt.

Die Einwirkung elektromagnetischer Strahlung auf Materie, insbesondere auf eine Vielzahl unterschiedlich geladener Teilchen, ist sehr komplex. Noch komplexer werden diese Einwirkungen, wenn den elektromagnetischen Feldern statische Felder überlagert werden. Statische elektrische Felder bewirken bekanntlich eine Beschleunigung eines geladenen Teilchens in Richtung des elektrischen Feldvektors. Ein geladenes Teilchen bewegt sich also im homogenen elektrischen Feld geradlinig unter dem Einfluß einer konstanten Kraft, d. h. die Geschwindigkeit wächst proportional mit der Zeit und die kinetische Energie nimmt quadratisch zu.

Der Einfluß eines statisch magnetischen Feldes ist in der Fig. 4 skizziert. Bewegt sich ein Träger elektrischer Ladung in einem homogenen Magnetfeld B, so wird, da die Lorenz-Kraft 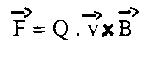 stets normal zur Geschwindigkeit i und damit normal zum Weg orientiert ist, der Ladungsträger keine Energie aus dem Magnetfeld aufnehmen. Die kinetische Energie des Ladungsträgers Wₖₘ = 1/2 mv² bleibt daher konstant und damit auch der Betrag seiner Geschwindigkeit. Die Winkelgeschwindigkeit, mit der ein Teilchen im Magnetfeld umläuft, beträgt 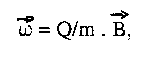 d.h. sie ist nicht von der Geschwindigkeit des Ladungsträgers abhängig. Ihr Betrag wird als Umlaufs- oder Gyrationsfrequenz bezeichnet. Die Frequenz ω wird gelegentlich auch Larmor-Frequenz genannt, was jedoch irreführend ist, denn in der Atomphysik bezeichnet man als Larmor-Frequenz die Präzessionsfrequenz eines elektrisch gebundenen Elektrons. Diese ist gerade halb so groß wie die Gyrationsfrequenz. Bewegt sich ein geladenes Teilchen in statisch überlagerten elektrischen und magnetischen Feldern, so ist seine Bewegungsgleichung

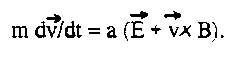

In der Fig.5 ist dargestellt, daß das Teilchen bei gekreuzten Feldern E̅ , B̅ eine Zykloidenbahn beschreibt. In den gekreuzten Feldern wird das Teilchen während seiner Gyration um die magnetische Feldlinie vom elektrischen Feld beschleunigtodergebremst. Die Gyration mit einer festen Geschwindigkeit und die überlagerte Drift mit einer anderen Geschwindigkeit ergeben eine Zykloide, deren Drehsinn dem der Gyration entspricht.

Wirken statt statisch elektrischer und magnetischer Felder statisch magnetische Felder und Hochfrequenz-Wechselfelder auf ein geladenes Teilchen ein, sowird dessen Bahn noch komplizierter und ist analytisch kaum mehr zu erfassen. Trotzdem spielt die letztgenannte Feldüberlagerung in der Praxis eine große Rolle, weil durch dieses Zusammenwirken die sogenannte Elektronen-Zyklotron-Resonanz (ECR) erzeugt wird, die seit langem bekannt ist (J.S. Townsend and E. W. B. Gill, Phil. Mag. 26,1938, Seite 290).

Die ECR-Resonanz tritt t auf, wenn die Gyrationsfrequenz f = B. Q/2π. m des Elektrons gleich der Frequenz der Mikrowelle ist (Ogawa und Abe, Nuclear Instruments and Methods 16,1962, S. 227 bis 232). Ein Elektron, das in einem homogenen statischen Magnetfeld durch ein elektrisches linearpolarisiertes Wechselfeld beschleunigt wird, beschreibt eine Spiralbahn, wenn die Frequenz des Wechselfelds und die Stärke des Magnetfelds den ECR-Bedingungen genügen. Die Energie des Elektrons erhöht sich bei jedem Umlauf, und die Beschleunigung hat einen sinusförmigen Verlauf. Nachteilig ist indessen bei Anregung einer Elektronen-Zyklotron-Resonanz mit linear polarisierten Wellen, daß die anregende linear polarisierte Welle im Plasma in zwei zirkular polarisierte Wellen zerlegt wird. Eine dieser Komponenten kann nicht weit in ein Plasma eindringen, weil sie reflektiert wird. Damit ist die Effektivität dieser Einkopplung schlecht. Außerdem ist nachteilig, daß die Beschleunigung des Elektrons einen zeitlich sinusförmigen Verlauf hat. Besser wäre es, wenn das Elektron kontinuierlich beschleunigt würde. Dies geschieht mit der erfindungsgemäßen Maßnahme, daß eine zirkular polarisierte Welle in das Plasma eingespeist wird.

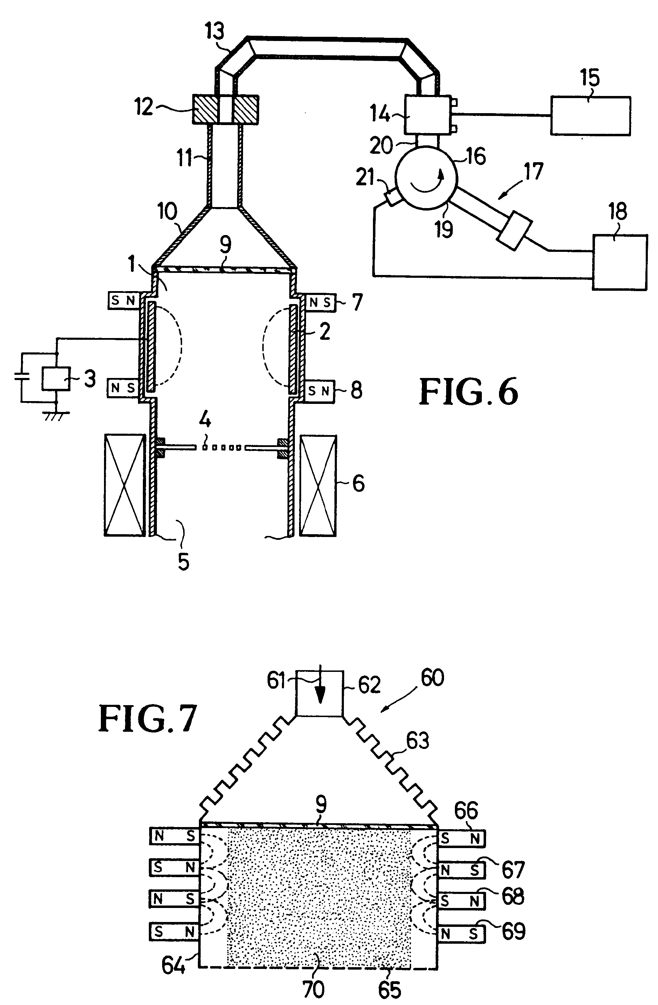

In der Fig. 6 ist eine Einrichtung für die Erzeugung eines Plasmas dargestellt, die einen topfförmigen Plasmaraum 1 aufweist, in dem sich ein Substratträger 2 befindet, der an einer Spannungsquelle 3 liegt und aus dem Teilchen herausgeschlagen und als Ionen von einem Gitter 4 abgesogen und in einen Raum 5 gebracht werden, der von einem Elektromagneten 6 umgeben ist. Der Plasmaraum 1 ist außerdem mit einer nicht dargestellten Gaszuführung verbunden.

Um den Plasmaraum 1 herum sind mehrere Dauermagnete ringförmig angeordnet, von denen nur zwei Dauermagnete 7,8 dargestellt sind, die in Verbindung mit einer Mikrowelle ECR-Bedingungen erzeugen. Die Dauermagnete umgeben den zylindrischen Plasmaraum 1 in der Weise, daß auf dem Umfang in vertikaler Richtung jedem Nordpol ein Südpol und jedem Südpol ein Nordpol folgt etc. Hierdurch ergibt sich ein sogenanntes magnetisches cusp-Feld.

Die in den Raum gelangenden Mikrowellen sind zirkular polarisiert und werden über eine durchsichtige Quarzabdeckung 9 zugeführt. An diese Quarzabdeckung ist ein trichterförmiger Horn-Wellenleiter 10 angesetzt, der in einen Rundhohlleiter 11 übergeht. Der Rundhohlleiter 11 ist seinerseits mit einem Transformator oder Wandler 12 gekoppelt, der mit einem Rechteckhohlleiter 13 in Verbindung steht. Der Rechteckhohlleiter 13, bei dem es sich um einen R26-Rechteckhohlleiter handeln kann, ist mit einer Abstimmeinheit 14 verbunden, die über eine Verstelleinrichtung 15 verstellt werden kann. Mit der Abstimmeinheit 14 ist ein Zirkulator 16 verbunden, der aus einem Magnetron 17 gespeist wird. Die Stromversorgung sowohl für das Magnetron 17 wie auch für den Zirkulator 16 erfolgt aus einer Stromversorgung 18.

Statt eines Magnetrons 17 kann selbstverständlich auch ein anderer Mikrowellenerzeuger, z. B. ein Klystron, verwendet werden. Bei dem Magnetron 17 handelt es sich um eine Magnetfeldröhre, die bei Frequenzen im GHz-Bereich als Oszillator dient. Die aus einer Glühkathode austretenden Elektronen werden durch Felder so beeinflußt, daß sie abgetrennt werden und einen Teil ihrer kinetischen Energie abgeben. Durch diese Energie werden Schwingungen erzeugt, so daß über Auskoppelleitungen Energie an einen Verbraucherzugeführt werden kann.

Bei dem Zirkulator 16 handelt es sich um ein passives, nichtreziprokes Mehrtor, bei dem die in ein Tor eingespeiste Mikrowellenleistung um eine geringe Durchgangsdämpfung geschwächt nur an einem Tor 20 abgegeben wird, während ein anderes Tor 21 weitgehend entkoppelt ist. Die Abstimmeinheit 14 dient zur Abstimmung des nachgeschalteten Rechteckhohlleiters 13 auf die Versorgung. Durch den Rechteckhohlleiter 13 werden die Mikrowellen auf den Wandler 12 geführt. Der Modenwandler 12 wandelt die rechteckverteilten und linear polarisierten Wellen in kreisverteilte und zirkular polarisierte Wellen um. Die H₁₁ ist in dem Modenwandler bevorzugt ausbreitungsfähig. Von dem Modenwandler gelangen die Wellen in den Rundhohlleiter 11. Dieser Rundhohlleiter 11 wird in einem Frequenzbereich betrieben, in dem nur die Hₗₗ-Grundwelle ausbreitungsfähig ist. Der Rundhohlleiter 11 ist also gewissermaßen ein Durchlaßfilter für zirkular polarisierte Hₗₗ-Wellen. Anschließend werden die zirkular polarisierten Mikrowellen über den kreiszylindrischen Hornstrahler 10 in den Plasmaraum 1 eingekoppelt. Als Rundhohlleiter 11 wird z. B. bei einer Mikrowellenfrequenz von 2,45 GHz ein C25-Rundhohlleiter mit einem Innendurchmesservon 8,26 cm verwendet. Da bei einer Frequenz von 2,45 GHz der Grenzdurchmesser der H₁₁-Grundwelle 7,02 cm ist und der nächst höhere (Eₒᵢ-)Mode bei einem Durchmesser von 9,16 cm ausbreitungsfähig wird, muß der Innendurchmesserdes Rundhohlleiters 11 zwischen diesen beiden Grenzwerten liegen, um eine eindeutige Anregung der zirkular polarisierten Welle zu ermöglichen. Der zylindrische Plasmaraum 1 hat bei den erwähnten Abmessungen des Rundhohlleiters 11 einen Durchmesser von 30 cm. Hier sind bei 2,45 GHz bereits mehr als zehn Moden ausbreitungsfähig.

Die Einspeisung der zirkular polarisierten Welle erfolgt, wie bereits erwähnt, über das rotationssymmetrische Horn 10, wodurch winkelabhängige höhere Moden nicht angeregt werden. Für den Aufbau des Modenwandlers 12 sind verschiedene Varianten aus der Literatur bekannt (D. Thombs, Th. Sikina, "Use Circular Feed To Balance Outputs From Square Horns", Microwave & RF, März 1989,S. 87 bis 95).

In der Fig.7 ist das Prinzip einer Mikrowelleneinstrahlung mittels eines Rillenhorns dargestellt. Bei diesem Rillenhorn 60 wird die Mikrowelle 61 an einem oberen Hals 62 eingespeist, der in einen kegelförmigen und gerillten Bereich 63 übergeht. Dieser Bereich 63 schließt an ein Zylindergefäß 64 mit einer Glastrennwand 9 und einem Absauggitter 65 an. Um das Zylindergefäß 64 sind mehrere als Ringe ausgebildete Dauermagnete 66 bis 69 gelegt, deren Polarität sich in vertikaler Richtung ändert. In dem Zylindergefäß 64 befindet sich das Plasma 70. Zwischen der erreichbaren Plasmadichte und der Wellenlänge der zirkular polarisierten Welle im Plasma besteht ein Zusammenhang. Das Plasma befindet sich in einem Wellenleiter, der durch das einspeisende Horn 63 und den zylindrischen Bereich der Magnete 66 bis 69 gebildet wird. Für eine hohe Kopplung zwischen den Plasmawellen und der eingespeisten Welle ist es wünschenswert, daß die Wellenlänge in der Einspeisungsstruktur ohne Plasma möglichst nahe an der Plasma-Wellenlänge liegt. Durch die Wandimpendanz des Rillenhorns 60 läßt sich die Wellenlänge beeinflussen und damit für eine möglichst hohe Kopplung optimieren.

Weiterhin kann mit einem Rillenhorn eine zirkulare Polarisation besser aufrechterhalten werden. In Hohlräumen können diverse Moden existieren, die voneinander unabhängig sind. Bei der Einspeisung eines Wellentyps an einer bestimmten Stelle ist daher noch nicht gesagt, daß dessen Charakteristik auch an anderen Stellen in den Strukturen vorliegt. Besser als bei Hohlraumstrukturen ist der Zusammenhang bei einem glatten Horn. Jedoch können auch hierdurch die nicht ideal zu realisierende Geometrie die Moden auseinanderlaufen, wodurch die Polarisation verändert wird. Ein Rillenhorn koppelt jedoch die verschiedenen Moden und hält dadurch die Polarisation zusammen. Zusätzlich kann in einem Rillenhorn eine Impedanztransformation durchgeführt werden, wodurch die Anpassung an den eingespeisten Hohlleiter verbessert wird.

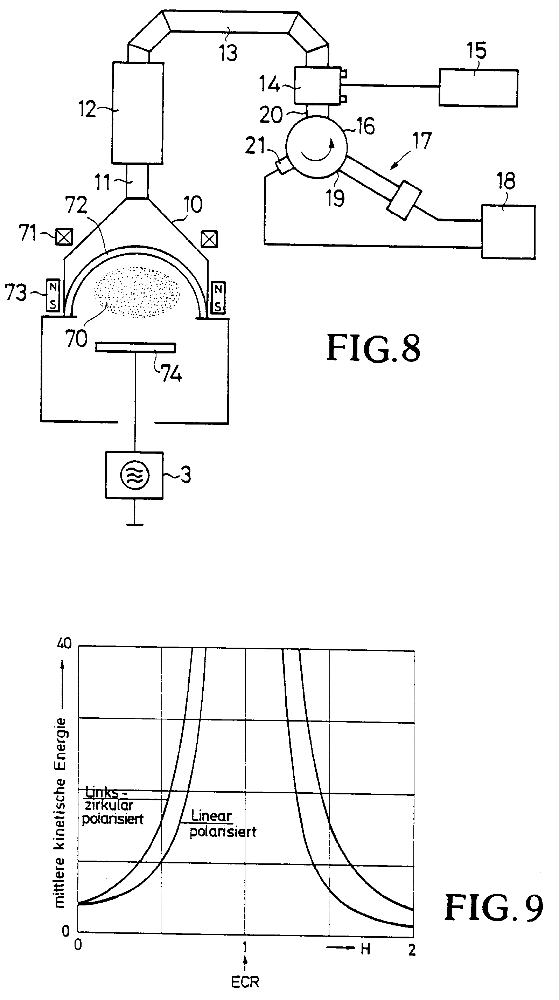

In der Fig. 8 ist eine ähnliche Vorrichtung wie in der Fig. 6 dargestellt, bei dergleiche Bauteile mit denselben Bezugszahlen versehen sind. Die elektrisch nichtleitende Begrenzungswand zwischen dem Plasmaraum und dem kreiszylindrischen Einstrahlungstrichter 10 ist hierbei eine Quarzglocke 72. Diese Quarzglocke 72 ist von einem ringförmigen Dauermagneten 73 umgeben, dessen Nord- und Südpol so ausgerichtet sind, daß sie ein cuspförmiges Feld im Plasma 70 erzeugen, welches die Voraussetzung für eine ECR-Bedingung ist. Ein Elektromagnet 71 für die Führung geladener Teilchen ist oberhalb der Quarzglocke 72 vorgesehen. Er entspricht hinsichtlich seiner Wirkung dem Elektromagnet 6 gemäß Fig. 6. Mit 74 ist ein Substratträger bezeichnet, der an der Spannungsquelle 3 liegt und ein zu beschichtendes oder ätzendes Substrat trägt. Die Gaszuführung, welche das zu ionisierende Gas in die Plasmakammer einführt, ist der Einfachheit halber nicht dargestellt.

Die Elemente 11 bis 16 sind für die Einspeisung zirkular polarisierter Wellen erforderlich, weil herkömmliche Mikrowellenerzeuger wie Magnetrons nur linear polarisierte Wellen liefern. Deshalb muß ein Wellentypwandler oder Modenwandler 12 zwischengeschaltet werden. Außerdem wird eine effektive Wirkleistungsübertragung der Mikrowelle in das Plasma 70 benötigt, wozu die Kombination aus Rundhohlleiter 11 und Horn 10 dient. Ein kontinuierlicher Übergang zwischen unterschiedlichen Wellenleiter-Durchmessern trägt zur Stabilisierung bei Plasmaschwankungen bei, wie sie im realen Betrieb von Plasmaquellen unvermeidbar sind.

Für unterschiedliche Betriebsbedingungen müssen besondere Anpassungsmaßnahmen getroffen werden. Mit Hilfe der Abstimmeinheiten 14,15 und des Zirkulators 16 mit den Toren 19,20,21 kann die Mikrowelle gezielt, d.h. nachmeßbar, an verschiedene Plasmalasten angepaßt werden. Das Magnetron 17 kann aufgrund einer solchen Anpassung für die verschiedensten Gasarten und Substrate verwendet werden.

Der Modenwandler 12 besitzt oben einen Eingang als R26 -Rechteckhohlleiter und unten einen Ausgang als C25-Rundhohlleiter. Der Rundhohlleiter kann sehr kurz ausgebildet sein. Er wird in einem Frequenzbereich betrieben, in dem nur die H₁₁-Grundwelle ausbreitungsfähig ist.

In der Fig. 9 ist auf der Ordinate die mittlere kinetische Energie eines Elektrons in Abhängigkeit von der auf der Abszisse aufgetragenen magnetischen Feldstärke dargestellt. Das magnetostatische Feld ist orthogonal zum elektrischen Feld der Mikrowelle angeordnet. Die Darstellung zeigt zum einen die mittlere kinetische Energie bei Einstrahlung einer linear polarisierten Welle und zum anderen bei Einstrahlung einer zirkular polarisierten Welle. Beide Kurven besitzen einen Pol an der Stelle, an der das Magnetfeld die ECR-Bedingung erfüllt. Die Energie eines durch eine zirkular polarisierte Welle beschleunigten Teilchens ist höher als diejenige bei linearer Polarisation. Insbesondere im Bereich zwischen der halben und der anderthalbfachen magnetischen Feldstärke der ECR-Feldstärke ist die Energie etwa doppelt so groß. Für die linear polarisierte Welle gilt 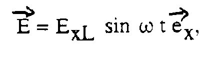 während für die zirkular polarisierte Welle 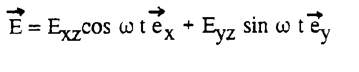 gilt. Weiterhin gilt E_{xL} = V2 E_{xz} -√2 Ey_{z}.

Im übrigen wird der Feldstärkenbereich, in dem der ECR-Effekt technisch wirksam ist, um ca. 40 % vergrößert. Da in der praktischen Realisierung kein homogenes Magnetfeld erzeugt werden kann, vergrößert sich damit das Volumen, in dem das quasi-ECR-Plasma angeregt werden kann.

Unter Mikrowellen werden elektromagnetische Wellen mit einer Frequenz im Bereich von 300 MHz bis 300 GHz beziehungsweise mit Wellenlängen λ = c/f von 1 m bis 1 mm verstanden.

## Patentansprüche

1. Einrichtung für die Erzeugung von zirkular polarisierten Mikrowellen, mit
1.1 einem Mikrowellenoszillator (17);
1.2 einem Rechteck-Hohlleiter (13), der mit dem Mikrowellenoszillator (17) verbunden ist und der die von diesem Mikrowellenoszillator (17) kommenden linear polarisierten Mikrowellen leitet;
1.3 einem Modenwandler (12), der mit dem Rechteck-Wellenleiter (13) verbunden ist und der die vom Rechteck-Wellenleiter (13) kommenden linear polarisierten Mikrowellen in zirkular polarisierte Mikrowellen umwandelt,
gekennzeichnet durch folgende Merkmale:
1.4 in dem Modenwandler (12) breitet sich die zirkular polarisierte H₁₁-Grundwelle bevorzugt aus,
1.5 der Modenwandler (12) ist fest mit dem Rechteck-Wellenleiter (13) verbunden;
1.6 an den Modenwandler (12) schließt sich ein kreiszylindrischer Hohlleiter (11) an, der mit seinem Eingang fest mit dem Ausgang des Modenwandlers (12) verbunden ist, wobei der Innendurchmesser dieses Hohlleiters (11) über die ganze Länge des Hohlleiters (11) konstant und so dimensioniert ist, daß sich nur die H₁₁-Grundwelle in ihm ausbreiten kann;
1.7 ein trichterförmiger Horn-Wellenleiter (10), der einen kleinen und einen großen inneren Querschnitt aufweist, ist so angeordnet, daß seine Eingangsöffnung mit dem kleinen Querschnitt fest mit dem Ausgang des kreiszylindrischen Wellenleiters (11) verbunden ist;
1.8 eine Plasmakammer (1, 21, 64), die ein Gehäuse mit einem Fenster (9) aufweist, durch welches Mikrowellen eintreten können, wobei der Bereich dieses Fensters (9) von dem Ausgang des trichterförmigen Horn-Wellenleiters (10) mit dem großen inneren Querschnitt überdeckt ist;
1.9 Magnete (7, 8) mit einem konstanten Magnetfeld, das in die Plasmakammer (1, 21, 64) eindringt und das orthogonal zum elektrischen Feld der Mikrowellen ausgerichtet ist.

2. Einrichtung nach Anspruch 1, dadurch gekennzeichnet, daß der Horn-Wellenleiter (10) mit glatter Oberfläche ausgebildet ist.

3. Einrichtung nach Anspruch 1, dadurch gekennzeichnet, daß der Horn-Wellenleiter ein Rillenhorn (60) ist.

4. Einrichtung nach Anspruch 1, dadurch gekennzeichnet, daß mehrere Magnete (6, 7, 71, 73) um die Plasmakammer herum angeordnet sind.

5. Einrichtung nach Anspruch 1, dadurch gekennzeichnet, daß der kreiszylindrische Hohlleiter (11) bei einer Mikrowellenfrequenz von 2,45 GHz einen Innendurchmesser von zwischen 7,02 cm und 9,16 cm aufweist.

6. Einrichtung nach Anspruch 5, dadurch gekennzeichnet, daß der kreiszylindrische Hohlleiter (11) ein C25-Rundhohlleiter mit einem Innendurchmesser von 8,36 cm ist.

7. Einrichtung nach Anspruch 1, dadurch gekennzeichnet, daß die Plasmakammer mit einer glockenförmigen und elektrisch nichtleitenden Vorrichtung (72) zur Mikrowelleneinstrahlung hin abgeschlossen ist.

8. Einrichtung nach Anspruch 7, dadurch gekennzeichnet, daß unterhalb der Plasmakammer ein Substratträger (74) vorgesehen ist, der an einer Spannungsquelle (3) liegt.

9. Einrichtung nach Anspruch 7, dadurch gekennzeichnet, daß die Vorrichtung (72) von einem ringförmigen Dauermagneten (73) umgeben ist, der ein in das Plasma ragendes cusp-Feld erzeugt.

10. Einrichtung nach Anspruch 1, dadurch gekennzeichnet, daß zwischen Mikrowellenoszillator (17) und dem Rechteck-Hohlleiter (13) eine Anpassungseinrichtung (14, 15) vorgesehen ist.

11. Einrichtung nach Anspruch 1, dadurch gekennzeichnet, daß dem Mikrowellenoszillator (17) ein Zirkulator (16) nachgeschaltet ist.

12. Einrichtung nach Anspruch 7, dadurch gekennzeichnet, daß oberhalb der Vorrichtung (72) ein ringförmiger Elektromagnet (71) vorgesehen ist.

13. Einrichtung nach Anspruch 1, dadurch gekennzeichnet, daß der Modenwandler (12) die aus einem Rechteckhohlleiter (13) kommenden linear polarisierten und rechteckverteilten Mikrowellen in kreisverteilte zirkular polarisierte Wellen umformt.

## Claims

1. Device for the generation of circularly polarized microwaves, comprising
1.1 a microwave oscillator (17);
1.2 a rectangular waveguide (13) which is connected to the microwave oscillator (17) and which conducts the plane-polarized microwaves coming from said microwave oscillator (17);
1.3 a mode converter (12) which is connected to the rectangular waveguide (13) and which converts the plane-polarized microwaves coming from the rectangular waveguide (13) into circularly polarized microwaves, characterized by the following features:
1.4 the circularly polarized H₁₁ fundamental wave preferably propagates in the converter (12);
1.5 the mode converter (12) is firmly connected to the rectangular waveguide (13);
1.6 adjacent to the mode converter (12) is a circular-cylindrical waveguide (11) whose input is firmly connected to the output of the mode converter (12), the internal diameter of said waveguide (11) being constant over its entire length and dimensioned so that only the H₁₁ fundamental wave can propagate in it;
1.7 a funnel-shaped horn waveguide (10) having a small and a large internal cross section is so disposed that its inlet aperture having the small cross section is firmly connected to the output of the circular-cylindrical waveguide (11);
1.8 a plasma chamber (1, 21, 64) which has a housing having a window (9) through which microwaves can enter, the region of said window (9) being spanned by the output of the funnel-shaped horn waveguide (10) having the large internal cross section;
1.9 magnets (7, 8) having a constant magnetic field which enters the plasma chamber (1, 21, 64) and is aligned orthogonally with respect to the electric field of the microwaves.

2. Device according to Claim 1, characterized in that the horn waveguide (10) is designed with a smooth surface.

3. Device according to Claim 1, characterized in that the horn waveguide is a corrugated horn (60).

4. Device according to Claim 1, characterized in that a plurality of magnets (6, 7, 71, 73) is disposed around the plasma chamber.

5. Device according to Claim 1, characterized in that the circular-cylindrical waveguide (11) has an internal diameter of between 7.02 cm and 9.16 cm for a microwave frequency of 2.45 GHz.

6. Device according to Claim 5, characterized in that the circular-cylindrical waveguide (11) is a C25 circular waveguide having an internal diameter of 8.36 cm.

7. Device according to Claim 1, characterized in that the plasma chamber is terminated by a bell-shaped and electrically nonconducting fixture (72) with respect to the microwave radiation.

8. Device according to Claim 7, characterized in that a substrate support (74) which is connected to a voltage source (3) is situated underneath the plasma chamber.

9. Device according to Claim 7, characterized in that the device (72) is surrounded by an annular permanent magnet (73) which generates a cusp field projecting into the plasma.

10. Device according to Claim 1, characterized in that a matching device (14, 15) is provided between microwave oscillator (17) and the rectangular waveguide (13).

11. Device according to Claim 1, characterized in that a circulator (16) is connected to the output of the microwave oscillator (17).

12. Device according to Claim 7, characterized in that an annular electromagnet (71) is provided above the fixture (72).

13. Device according to Claim 1, characterized in that the mode converter (12) transforms the plane-polarized and rectangularly distributed microwaves coming from the rectangular waveguide (13) into circularly distributed circularly polarized waves.

## Revendications

1. Dispositif de production de micro-ondes polarisées circulairement, comportant
1.1 un oscillateur à micro-ondes (17);
1.2 un guide d'ondes rectangulaire (13), relié à l'oscillateur à micro-ondes (17) et qui guide les micro-ondes polarisées linéairement, en provenance de cet oscillateur de micro-ondes (17);
1.3 un convertisseur de modes (12), relié au guide d'ondes rectangulaire (13) et qui convertit les micro-ondes polarisées linéairement, en provenance du guide d'ondes rectangulaire (13), en micro-ondes polarisées circulairement,
caractérisé par les caractéristiques suivantes :
1.4 à l'intérieur du convertisseur de modes (12) se propage, de préférence, l'onde fondamentale H₁₁ polarisée circulairement;
1.5 le convertisseur de modes (12) est relié de façon fixe au guide d'ondes rectangulaire (13);
1.6 au convertisseur de modes (12) fait suite un guide d'ondes (11) cylindrique à base circulaire, dont l'entrée est reliée de façon fixe à la sortie du convertisseur de modes (12), le diamètre intérieur de ce guide d'ondes (11) étant constant sur toute la longueur du guide d'ondes (11) et présentant des dimensions telles que seule l'onde fondamentale H₁₁ peut se propager à l'intérieur;
1.7 un guide d'ondes en corne (10), en forme d'entonnoir, qui présente une petite et une grande section transversale intérieure, est disposé de telle sorte que son ouverture d'entrée, avec la petite section transversale, est reliée de façon fixe avec la sortie du guide d'ondes (11) cylindrique à base circulaire;
1.8 une chambre à plasma (1, 21, 64), qui présente un boîtier avec une fenêtre (9) à travers laquelle les micro-ondes peuvent pénétrer, la zone de la fenêtre (9) étant recouverte par la sortie du guide d'ondes en corne (10) en forme d'entonnoir avec la grande section transversale intérieure;
1.9 des aimants (7, 8) avec un champ magnétique constant, qui pénètre dans la chambre à plasma (1, 21, 64) et qui est orienté de façon orthogonale au champ électrique des micro-ondes.

2. Dispositif selon la revendication 1, caractérisé en ce que le guide d'ondes en corne (10) présente une surface lisse.

3. Dispositif selon la revendication 1, caractérisé en ce que le guide d'ondes en corne présente une forme de corne cannelée (60).

4. Dispositif selon la revendication 1, caractérisé en ce que plusieurs aimants (6, 7, 71, 73) sont disposés autour de la chambre à plasma.

5. Dispositif selon la revendication 1, caractérisé en ce que, pour une fréquence de micro-ondes de 2,45 GHz, le guide d'ondes (11) cylindrique à base circulaire présente un diamètre intérieur situé entre 7,02 cm et 9,16 cm.

6. Dispositif selon la revendication 5, caractérisé en ce que le guide d'ondes (11) cylindrique à base circulaire est un guide d'ondes circulaire du type C25, avec un diamètre intérieur de 8,36 cm.

7. Dispositif selon la revendication 1, caractérisé en ce que la chambre à plasma est fermée, du côté de l'irradiation par les micro-ondes, par un dispositif (72) en forme de cloche, ne conduisant pas l'électricité.

8. Dispositif selon la revendication 7, caractérisé en ce qu'est prévu, sous la chambre à plasma, un support de substrat (74), qui est en relation avec une source de tension (3).

9. Dispositif selon la revendication 7, caractérisé en ce que le dispositif (72) est entouré d'un aimant permanent (73) annulaire, qui produit un champ cuspidé pénétrant dans le plasma.

10. Dispositif selon la revendication 1, caractérisé en ce qu'un dispositif de réglage (14, 15) est prévu entre l'oscillateur de micro-ondes (17) et le guide d'ondes rectangulaire (13).

11. Dispositif selon la revendication 1, caractérisé en ce qu'un circulateur (16) est placé en aval de l'oscillateur de micro-ondes (17).

12. Dispositif selon la revendication 7, caractérisé en ce qu'est prévu, au-dessus du dispositif (72), un électroaimant (71) annulaire.

13. Dispositif selon la revendication 1, caractérisé en ce que le convertisseur de modes (12) convertit les micro-ondes, en provenance d'un guide d'ondes rectangulaire (13), distribuées selon un rectangle et polarisées linéairement, en ondes distribuées selon un cercle et polarisées circulairement.
